# EUROPEAN PATENT APPLICATION

(11) **EP 3 112 881 A1**
(43) Date of publication of application: **04.01.2017**
(21) Application number: 15175088.2
(22) Date of filing: 02.07.2015
(51) Int. Cl.: G01R 1/04, H05K 7/10

(54) **SYSTEM FOR MOUNTING A TEST SOCKET AND A TEST BOARD TO EACH OTHER, TEST BOARD AND TEST SOCKET**

(71) Applicant: Multitest elektronische Systeme GmbH, 83026 Rosenheim (DE)
(72) Inventor: YAKUSHEV, Sergey, Maple Grove, MN Minnesota 55311 (US); HANSON, Scott, Lino Lakes, MN Minnesota 55038 (US); LEE, Henry, deceased (SG)
(74) Representative: Dilg, Haeusler, Schindelmann Patentanwaltsgesellschaft mbH

(57) **Abstract**

A locking system (100) is provided for mounting a test socket (150) and a test board (190) to each other, wherein the test socket (150) and the test board (190) are used in an automated test equipment (900) to test electronic components (930). The locking system (100) comprises: a test board (190) wherein the test board (190) comprises a printed circuit board (191) and a locking pin (192a, 192b, 192c, 192d) extending from the printed circuit board (191). Further, the locking system (190) comprises a test socket (150) wherein the test socket (150) comprises a socket body (151) and a lock member (152) coupled to the socket body (151). The locking pin (192a, 192b, 192c, 192d) and the lock member (152) can lock with each other so that the test socket (150) and the test board (190) are fixed to each other.

## Description

### FIELD OF THE INVENTION

The invention relates to a system for mounting a test socket and a test board to each other. Further, the invention relates to a test board. Furthermore, the invention relates to a test socket.

### BACKGROUND OF THE INVENTION

Test sockets are used on test boards to test various parameters and/or components of semiconductor devices. Electronic devices have become smaller yet more powerful, resulting crowded and complex circuit boards. Given the complexity and size constraints of test boards, it can be difficult and time-consuming to mount the test socket, particularly by humans. In particular, it may be time consuming to change the test sockets by using screws for fastening.

### OBJECT AND SUMMARY OF THE INVENTION

There may be a need to accelerate the change of test sockets and to make the change of the test sockets less error-prone.

In order to achieve the object defined above, a system, a test board, and a test socket having the features according to the independent claims, are provided.

According to an exemplary embodiment of the invention a system is used for mounting a test socket and a test board to each other, wherein the test socket and the test board are used in an automated test equipment to test electronic components. The system comprises: a test board wherein the test board comprises a printed circuit board and a locking pin extending from the printed circuit board. Further, the system comprises a test socket wherein the test socket comprises a socket body and a lock member coupled to the socket body. The locking pin and the lock member can lock with each other so that the test socket and the test board are fixed to each other.

According to an exemplary embodiment of the invention a test board for testing electronic components in an automated test equipment comprises: a printed circuit board and a locking pin extending from the printed circuit board, wherein the locking pin is adapted to lock with a lock member of a test socket so that the test socket and the test board are fixed to each other.

According to an exemplary embodiment of the invention a test socket for testing electronic components in an automated test equipment comprises: a lock member and a socket body, the lock member being coupled to the socket body, wherein the lock member is adapted to lock with a locking pin extending from a printed circuit board so that the test socket and the test board are fixed to each other.

The following terms, definitions and explanations may apply to the system, the test board, and the test socket, as well.

The term "system" may denote a regularly interacting or interdependent group of items forming a unified whole. The system may be a locking system. The term "locking" may particularly denote fastening (as for a door) operated by a combination of parts. In accordance with a regular use of the term "locking", merely using a screw for screwing something on something else may not be called "locking" or is not locking something with something else.

The term "mount" may denote "to arrange or assemble for use".

The term "test socket" may denote the device which is sometimes also called "test contactor" and may provide or support contact springs for electrically contacting to an electronic component or "DUT" (device under test).

The term "test board" may particularly denote the board of electrical wiring and contact pads, and includs mechanical parts for fixing. The test board is situated behind the test socket, seen from the DUT. The term automated test equipment "ATE" is the general term for the automatic test systems comprising at least a handler, a test socket, a test board, and a tester, for testing electronic components, i.e. DUTs.

The term "printed circuit board" or "PCB" may particularly denote the board that comprises the pads for contacting to a test socket, further electric wiring, and pads to contact to the tester side of the ATE. In this sense mechanical devices attached or fixed to the PCB may be excluded from the term "printed circuit board".

The term "locking pin" may particularly denote a piece of solid material (e.g. metal) used for fastening things together. In particular, the locking pins may extend perpendicularly from the printed circuit board. The test socket may be centered on the PCB or aligned with the PCB by the locking pin.

The term "socket body" may particularly denote that part of the test socket comprising the spring contacts or any other contacts for contacting to the DUT.

The term "lock member" may be a part of the contact socket by which the locking is realized. The term "coupled to the socket body" may particularly denote that the lock member is movable relative to the socket body. The lock member may be movable in the main plane of the PCB. The term that the test board and the test socket are "fixed to each other" may in particularly denote that the combination of the test socket and the test board becomes firm or stable. In particular, the electrical contacting between the test board and the test socket may be provided, when the test board and the test socket are fixed to each other. However, the test socket and the test board may be releasable or removable fixed by using the system.

A gist of the invention is that a system which is easy to use for operators provides the accuracy for a multiple use in terms of accuracy of contacting between the contacts of the test board with the tester sided contacts of the test socket and the stability of mechanical fastening. This may be achieved by an interaction of a lock member (as a movable part of the test socket) with locking pins extending from the PCB. The movement of the lock member may be relative to the socket body of the test socket and relative to the locking pins. Thus, the lock member is also movable relative to the test board if the test socket is fixed to the test board. The test socket may be put on, inserted or "pined on" the locking pins of the test board.

The locking pin may have a pin head and the locking pin may have an annular groove. In particular, there may be two, three, four ore more locking pins.

The lock member may be a frame, or one, two or more parts of a frame. A locking device may comprise the locking of the pin head with an elongated partially stepped hole of the lock member. The pin head may penetrate the non-stepped part of the partially stepped elongated hole in the released condition of the test socket. The pin head may engage with the stepped part of the partially stepped elongated hole in the locked condition of the test socket.

Further, a stop mechanism may comprise spring-loaded ball bearing engaging with a groove. The spring-loaded ball bearing may be a part of the test socket and the groove may be a part of the lock member, or vice versa. The term "stop mechanism" may particularly denote a function of arresting motion of the lock member relative to the socket body in a certain position.

Further, a guide may comprise a screw with a screw head screwed on the socket body and a stepped elongated hole as a part of the lock member. The screw head may engage with the stepped part of the elongated hole so that the lock member can slide but not regularly be removed from the socket body.

The locking position and the release position may be identical for the locking device and the stop mechanism.

The length of shifting the lock member in the locking position and in the release position may be identical for the locking device, the stop mechanism, and the guide.

Further, the lock member may be slidably coupled to the socket body, and if the lock member is slid in a locking position relative to the socket body so that the test socket is in a locked condition, then the locking pin locks with the lock member so that the test socket and the test board are fixed to each other.

The terms "slide" and "slideably" may denote that something is caused to glide or slip. In particular, a moving piece (here the lock member) is guided by another part (here the socket body or parts of the socket body) along which the moving piece glides. The lock member may be slidably coupled to the socket body by a guide.

There may be a position of the lock member, namely the "locking position" which corresponds to the locked condition of the test socket. The locked condition may particularly denote a state or mode of the test socket in which the test socket is fixed to the test board.

Further, the lock member may be slidably coupled to the socket body, and if the lock member is slid in a release position so that the test socket is in a released condition, then the locking pin unlocks with the lock member, so that the test socket can be removed from the test board or lowered to the test board.

The term "release" may denote that something becomes free. Here the test socket becomes free from the locked condition. The released condition of the socket may correspond to a release position of the lock member.

There may be two locking positions of the lock member, the "locking position" and the "release position" which correspond to the locked condition and the released condition of the test socket.

The term "condition" may denote a state or a mode. Here, it means that the test socket has two different modes or states one of which is the locked condition and the other is the released condition.

Further, a stop mechanism between the lock member and the socket body may lock the lock member in a locking position and in a release position.

The term "system" may denote that there are several mechanisms which could define the system as a whole. One of these single mechanisms is the stop mechanism engaging a force between the socket body and the lock member. With the stop mechanism the locking position and the release position of the lock member may be mechanically defined. The lock member may click into the locking position and into the release position. Bringing the lock member in the locking position may comprise a movement opposite to bringing the lock member in the release position. The locked condition of the test socket may be an end position of the lock member relative to the socket body and may be opposite to an end position of the released condition.

The system may further comprise a mounting tool comprising a force transmission element. The lock member comprises an opposite force transmission element. The force transmission element and the opposite force transmission element may engage with each other so that the mounting tool enables to move the lock member by hand from the locking position to the release position, and vice versa.

The term "tool" may particularly denote a handheld device that aids in accomplishing a task. The mounting tool may comprise a force transmission element which may be a bolt or a pin or anything that could engage with an opposite force transmission element which then may be a groove or sleeve. The force transmission element and the opposite force transmission element engage in a way like as "slot and key" and it is not important which part works as slot and which part works as as key. The force transmission element may be the groove and the opposite force transmission element may be the key as well.

Furthermore, the mounting tool may comprise a hook and the socket body further comprises a latch, wherein the hook and the latch do not engage with each other when the test socket is in the locked condition so that the mounting tool and the test socket are removable from each other. The mounting tool may comprise a handle being fixedly coupled to a base plate of the mounting tool, so that shifting of the handle shifts the mounting tool. Moreover, the hook and the latch do engage when test socket is in the released condition so that the mounting tool and the test socket are fixed to each other.

As an alternative, the handle may extend in an eccentric which shifts the lock member, if the handle is twisted.

### BRIEF DESCRIPTION OF THE DRAWINGS

These and other characteristics of the invention will be clear from the following description of embodiments, given as non-restrictive examples, with reference to the attached drawings, wherein:
- Fig. 1: illustrates schematically an automated test equipment (ATE)
- Fig. 2: illustrates a perspective view of an assembly and a test board
- Fig. 3: illustrates a perspective view of a system
- Fig. 4: illustrates a perspective view of a mounting tool
- Fig. 5: illustrates a perspective view of a test socket
- Fig. 6: illustrates a perspective view of a test board
- Fig. 7: illustrates a top view of a test socket in a locked condition
- Fig. 8: illustrates a cross-sectional view of a test socket and a mounting tool
- Fig. 9: illustrates a detail of a test socket in a locked condition
- Fig. 10: illustrates a cross-sectional view of a test socket and a mounting tool
- Fig. 11: illustrates a detail of a test socket in a released condition
- Fig. 12: illustrates a top view of a test socket in a released condition
- Fig. 13: illustrates a cross-sectional view of a test socket, a mounting tool, and a test board
- Fig. 14: illustrates a cross-sectional view of a test board
- Fig. 15: illustrates a perspective view of a lock member
- Fig. 16: illustrates a detail of a test socket in a released condition
- Fig. 17: illustrates a top view of a test socket in a locked condition
- Fig. 18: illustrates a detail of a test socket in a locked condition
- Fig. 19: illustrates a cross-sectional view of a test socket, a mounting tool, and a test board
- Fig. 20: illustrate a method of mounting a test socket on a test board
- Fig. 21: illustrate a method of demounting a test socket from a test board

### DESCRIPTIONS OF EMBODIMENTS

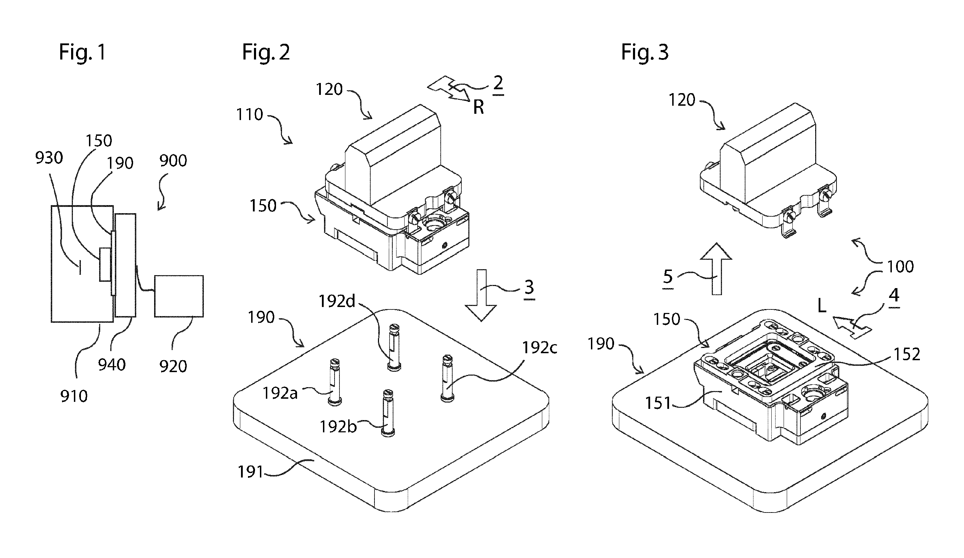

Fig. 1: The automated test equipment 900 comprises a handler 910 for handling electronic components 930. The handler 910 contacts the electronic component 930 to a test socket 150. The electronic component 930 is also called "DUT", as an abbreviation for "device under test". The test socket 150 is fixed to a test board 190 in a way, that tester sided contacts of the test socket 150 electrically contact to test socket sided contact pads of the test board 190. Thus, an electric contact is made from a DUT 930 to a tester 920. The tester 920 runs an electronic test routine for qualifying the DUT 930. A test head 940 helps to mechanically adjust the handler side with the test side of the ATE 900.

Referring to Fig. 3, the system 100 comprises a test socket 150 and a test board 190. The system 100 may additionally comprise a mounting tool 120, i.e. the system 100 then comprises the test socket 150, a test board 190, and the mounting tool 120. The test socket 150 comprises a socket body 151 and a locking member 152.

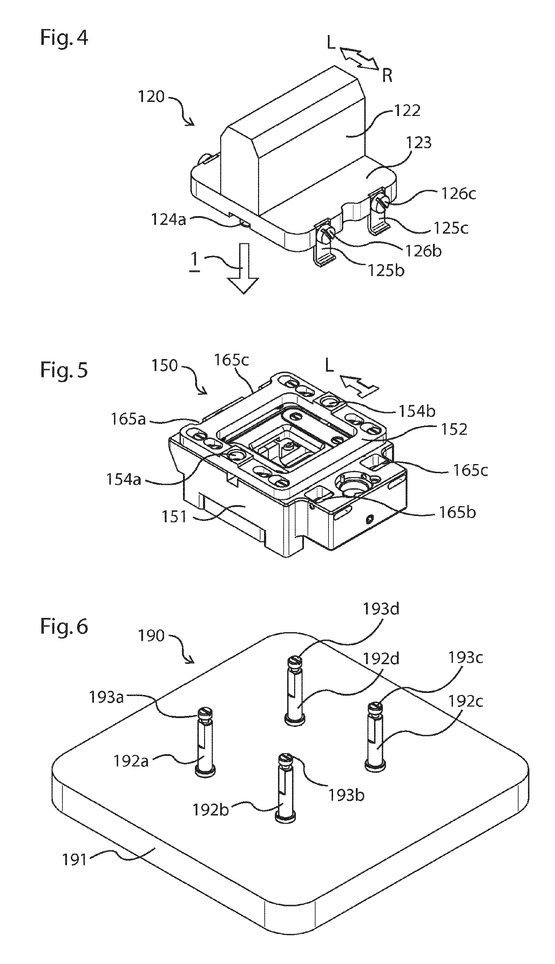

The mounting tool 120 illustrated in Fig. 4 comprises a handle 122 which enables to grip the mounting tool 120 by hand so that the mounting tool 120 is easier to be moved. The mounting tool 120 comprises also a base plate 123 to which the handle 122 is fixed to. The mounting tool 120 has at least one force transmission element 124a and at least one hook 125b or 125c. The at least one hook 125b or 125c may be fixed to the base plate 123 by at least one screw 126b, 126c, respectively.

In Fig. 5, the test socket 150 is in a locked condition "L". The locked condition L of the test socket 150 does not necessarily imply that the test socket 150 is fixed to the test board 190. The locked condition L may be a condition of the test socket 150, itself. Anyway, the test socket 150 may as well be fixed to the test board 190 in the locked condition L.

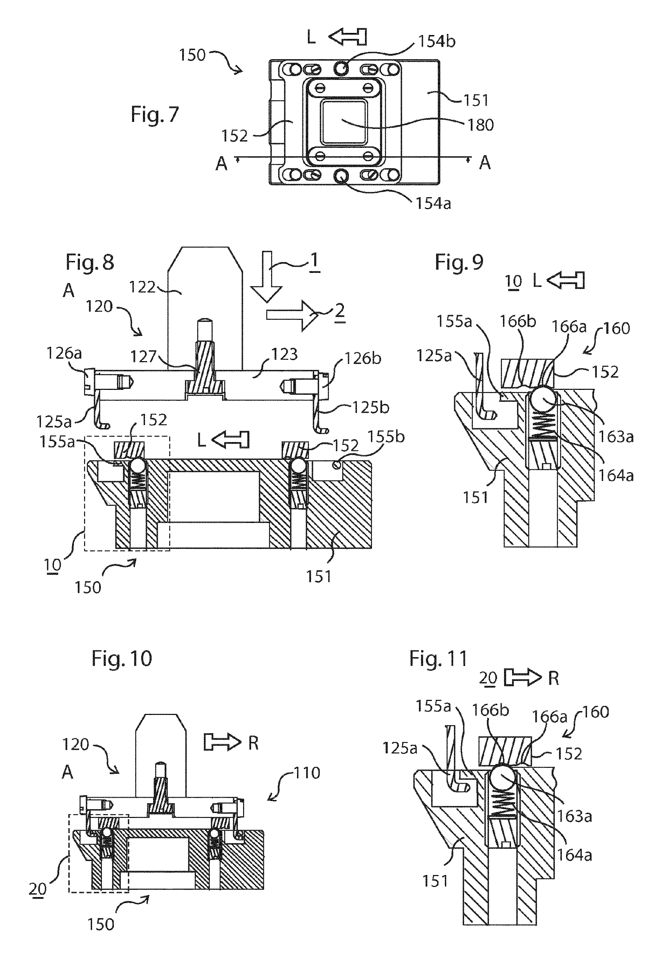

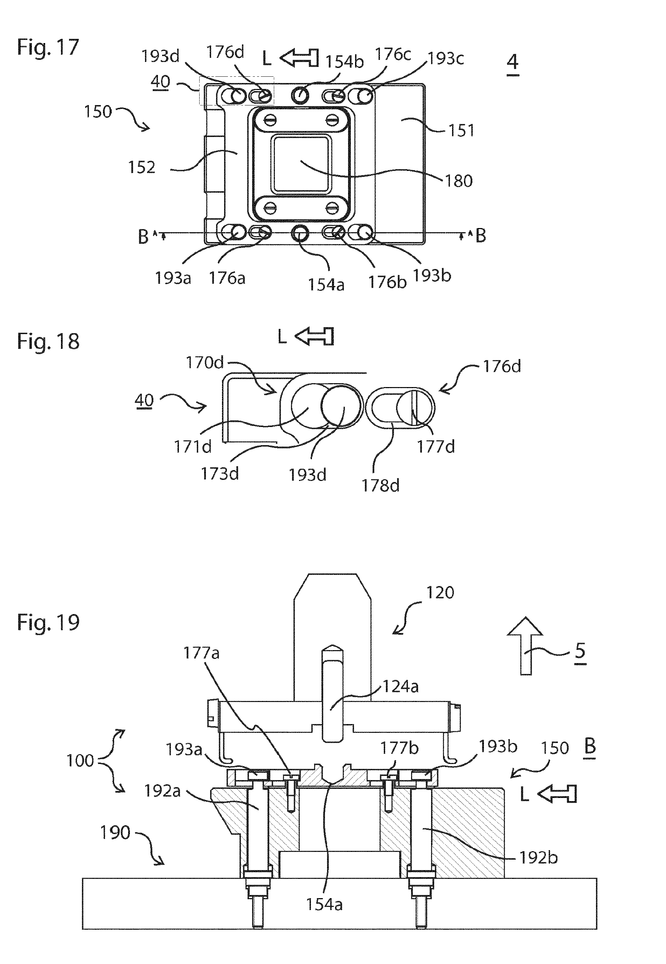

If the test socket 150 is in the locked condition L and fixed to the test board then the mounting tool 120 may be removable from the test socket 150. This allows using the center of the test socket 150, namely the contact area 180 (see Figs. 7 and 17), for contacting or testing the DUT 930. However, if the test socket 150 is in the locked condition L and not fixed to the test board 190 then the mounting tool 120 may be removable from the test socket 150 as well, for example for purposes of maintaining or storing the test socket 150.

Fig. 5 therefore shows a starting point when the test socket 150 is in a locked condition, for example the test socket 150 is just maintained and ready for use. Then the mounting tool 120 is put on the test socket 150 (see Fig. 4) in step 1.

If the mounting tool 120 and the test socket 150 are set together, like shown in Fig. 2, then the mounting tool 120 may be moved relative to the test socket 150 so that the test socket 150 then is in a released condition "R". The movement 2 of the mounting tool 120 is relative to the socket body 151 which will remain - in this case - unmoved. In the released condition R, the test socket 150 and the mounting tool 120 are fixed to each other. The mounting tool 120 and the test socket 150 being coupled to each other may constitute an assembly 110 which then could be lowered in step 3 to the test board 190.

Referring to Fig. 3, the mounting tool 120 could be shifted again, so that the test socket 150 is brought in his locked condition L (step 4). As a final action 5, the mounting tool 120 may be removed from the test socket 150, so that only the test socket 150 is fixed to the test board 190, and both being used as a whole in an ATE 900 for testing DUTs 930.

Fig. 6 shows that the test board 190 comprises a printed circuit board (PCB) 191 and locking pins 192a, 192b, 192c, 192d extending perpendicularly from the PCB 191. The locking pins 192a, 192b, 192c, 192d have an annular groove near the outmost end so that each of the locking pins 192a, 192b, 192c, 192d may have a pin head 193a, 193b, 193c, 193d on top. Each pin head 193a, 193b, 193c, 193d of each locking pin 192a, 192b, 192c, 192d may be a mechanical part by which the locking pins 192a, 192b, 192c, 192d are locked with the lock member 152 of the test socket 150 (compare Fig. 18).

Fig. 7 shows the test socket 150 from a top view and in the locked condition L. The lock member 152 may be a frame. The cross-section A is illustrated in Figs. 8 to 11 showing the mechanism of stop mechanism 160 and of the mechanism between the mounting tool 120 with the test socket 150.

The mounting tool 120 shown in Fig. 8 comprises the handle 122 and the base plate 123 both being fixed to each other by a screw 127. The hooks 125a and 125b are fixed by screws 126a and 126b, respectively, at opposite side sections of the base plate 123. The hooks 125a and 125b extend from the base plate 123 in a direction opposite the side to which the handle 122 extends to. The test socket 150 is in the locked condition L and comprises the socket body 151 and the lock member 152 showing two bars in the cross-sectional view A. The lock member 152 is arranged on the top side of the test socket 150, wherein the top side of the socket is defined as the contact side or the side from which the DUT 930 is contacted to the test socket 150.

The locked condition L of the test socket 150 is the starting point for the use of the test socket 150, so that the first step 1 is to lower the mounting tool 120 to the test socket 150. The second step 2 is to bring the test socket 150 from the locked condition L to the released condition R.

Detail 10 of Fig. 9 shows the stop mechanism 160 in the locked condition L of the test socket 150 whereas the detail 20 of Fig. 11 shows the released condition R both related to cross-section A.

In the locked condition L, the mounting tool 120 does not engage with the test socket 150, according to Fig.9. Therefore, the hook 125a can be lowered for a subsequent engaging with a latch 155a in the released condition R, as can be seen in Fig. 11.

Beside the interaction of the hook 125a and the latch 155a, Fig. 9 and 11 illustrate the stop mechanism 160 in the locked condition L and the released condition R, respectively. The lock member 150 may have a first groove 166a and a second groove 166b which stop the test socket 150 in its locked condition L and in the released condition R, respectively. Shifting or sliding the lock member 150 from the first groove 166a to the second groove 166b may correspond to a change of the locked condition L to the unlocked, namely the released condition R, and vice versa. A spring-loaded ball bearing may engage with grooves 166a, 166b. A ball 163a may be pressed by a spring 164a so that the ball 163a engages with the first groove 166a and the second groove 166b, respectively, for locking the position of the lock member 152.

In Fig. 10 the assembly 110 comprising the test socket 150 and the mounting tool 120 illustrates that the test socket 150 is in the released condition R where the mounting tool 120 is fixedly coupled to the test socket 150. The detail 20 of Fig. 11 shows that the hook 125a of the mounting tool 120 engages with the latch 155a of the socket body 151. The latch 155a may be a nose whereas the latch 155b on the opposite side of the socket may be a rod. In the released condition R the lock member 152 is shifted relative to the socket body 151, so that the ball 163a engages with the second groove 166b.

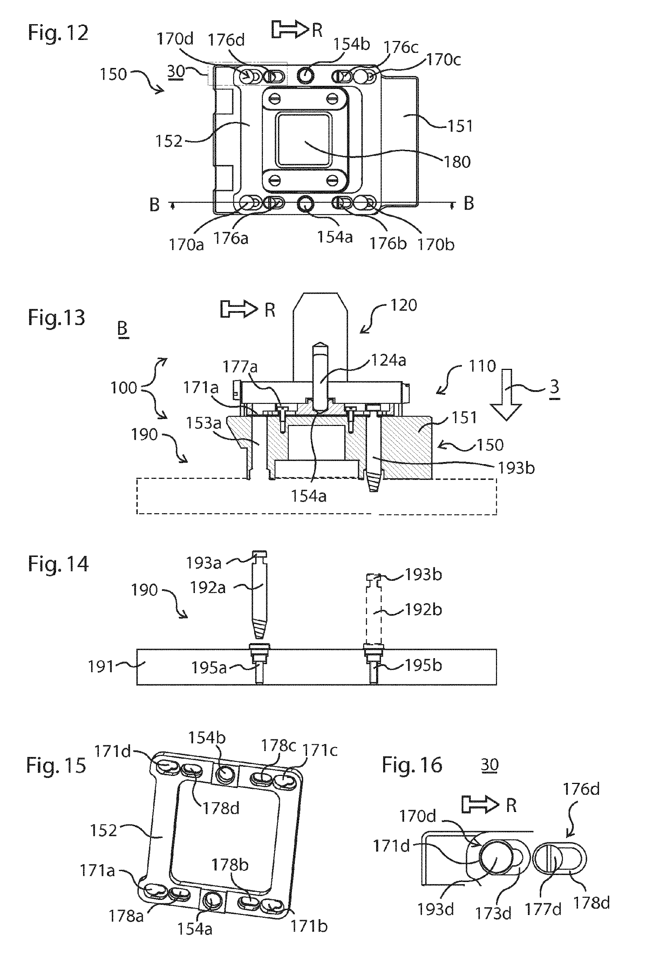

Fig. 12 illustrates the same plan view like Fig. 7 with the difference that the test socket 150 is in the released condition R. The released condition R will be illustrated in more detail in Fig. 16. Additionally, Fig. 12 illustrates the cross-section B which is different from cross-section A, like marked in Fig. 7.

Fig. 12 illustrates that there are four guides 176a, 176b, 176c, 176d near the corners of the lock member 152. There are also four locking devices 170a, 170b, 170c, 170d at the corners of the lock member 152. The mechanism of the guides 176a, 176b, 176c, 176d and the locking devices 170a, 170b, 170c, 170d will be discussed in Fig 16 as depicted by the detail 30.

The cross-section B illustrated in Fig. 13 shows the system 100 comprising at least the test socket 150 and the test board 190. However, following the released condition R as shown in Fig. 11 and Fig. 12, in step 3, the assembly 110, (comprising the test socket 150 coupled to the mounting tool 120), may be lowered towards the test board 190. In this cross-section B the force transmission element 124a is shown as a bolt and the opposite force transmission element 154a may be a groove. Engagement of the engaging element 124a and the opposite engaging element 154a enables that by moving the mounting tool 120 along the main plane of the test socket 150 may shift the lock member 152 along the same main plane corresponding to the locked condition L and to the released condition R.

When lowering the test socket 150 to the test board 190 the locking pins 192a, 192b, 192c, 192d penetrate the a bearing hole 153a of the test socket 150 in which the locking pins 192a, 192b, 192c, 192d closely fit. Subsequently, the heads 193a, 193b, 193c, 193d of the test board penetrate through holes 171a, 171b, 171c, 171d of the lock member 152, respectively.

As shown in Fig. 14, the locking pins 192a, 192b may be screwed in sleeves 195a, 195b having internal threads. Alternatively, the locking pins 192a, 192b, 192c, 192d may be formed from one piece and may be fixed to the PCB 191.

Fig. 15 is an illustration of the lock member 152 comprising the structures of the opposite force transmission elements 154a, b the stepped elongated holes 178a-d and the partially stepped through holes 171a-d. Fig. 16 illustrates the detail 30 depicted in Fig. 12.

The stepped elongated hole 178d serves together with the guiding screw 177d as the guide 176d so that the lock member is slidably coupled to the socket body 151 of the test socket 150.

The locking device 170d comprises the through hole 171d which is an elongated hole having a stepped section 173d and an elongated section of the through hole 171d. Further, the locking device 170d comprises the pin head 193d of the locking pin 192d. The pin head 193d of the locking pin 192d extends through the through hole 171d in the released condition R of the test socket 150 (see Fig. 16). If the test socket 150 is shifted in the locked condition L as shown in Fig. 18, and the pin head 192d of the locking pin 191d engages with the stepped section 173d of the through hole 171d.

Fig. 17 illustrates the same top view of the test socket 150 like shown in Fig. 12 with the difference that the lock member 152 is shifted in Fig. 17 in the locked condition L and that the lock member 152 is shifted in Fig. 12 in the released condition R. This condition or state may follow if the test socket 150 should be locked to the test board 190 after doing step 4 (see again Fig. 17).

A difference between the locking device 170d and the guide 176d is: The screw head 177d of the guide 176d engages with the stepped elongated through hole 178d in the locked condition L and in the released condition R whereas the pin head 193d of the locking pin 192d extends freely through the through hole 171d in the released condition R and engages with the stepped section 173d of the through hole 171d in the locked condition L. The lengths of shifting the lock member 152 in the locked condition L and in the released condition R may be identical for all of the locking device 170d, the guide 176d, and the stop mechanism 160.

Fig. 19 illustrates the system 100 wherein the mounting tool 120 is removed from the test socket 150 so that the contact area 180 is accessible for testing of the DUTs.

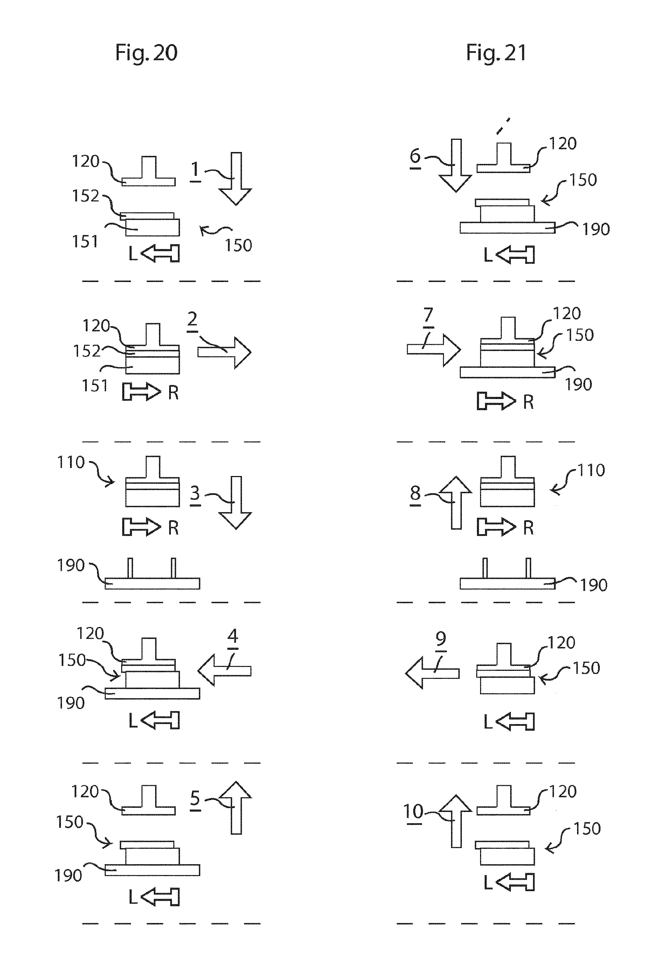

Fig. 20 illustrates schematically how a test socket 150 is mounted on the test board 190. First the test socket 150 comprising the socket body 151 and the lock member 152 is in the locked condition L. The mounting tool 120 is then lowered towards the test socket 150 in step 1. Then, in step 2 the lock member 152 is shifted relative to the socket body 151, so that the test socket is in the released condition R. The combination comprising the test socket 150 being in the released condition R and the mounting tool 120 may be the assembly 110. The assembly 110 is lowered towards the test board 190 in step 3. Then, in step 4, the test socket 150 is brought in the locked condition L, by locking the test socket 150 on the test board 190. The test socket 150 is brought in the locked condition L by shifting the lock member 152 in the opposite direction in comparison to step 2, where the test socket is brought in the released condition R. After step 4, the mounting tool 120 is removed from the test socket 150 in step 5.

Fig. 20 illustrates schematically how a test socket 150 is demounted or removed from the test board 190. The mounting tool 120 is lowered towards the test socket 150 which is in the locked condition L in step 6. In the following step 7, the test socket is brought in the released condition R by shifting the lock member 152. Then the so defined assembly 110 is removed from the test board 190 in step 8. The test socket can be brought in the locked condition L again, in step 9. In the subsequent step 10, the mounting tool 120 may be removed from the test socket 150. The test socket 150 is then in the locked condition L and ready for maintaining.

## Claims

1. A system (100) for mounting a test socket (150) and a test board (190) to each other, wherein the test socket (150) and the test board (190) are usable in an automated test equipment (900) to test electronic components (930), wherein the system (100) comprises:
a test board (190) comprising a printed circuit board (191) and a locking pin (192a, 192b, 192c, 192d) extending from the printed circuit board (191), and
a test socket (150) comprising a socket body (151) and a lock member (152) coupled to the socket body (151), wherein the locking pin (192a, 192b, 192c, 192d) and the lock member (152) can lock with each other so that the test socket (150) and the test board (190) are fixed to each other.

2. The system (100) according to claim 1, wherein
the lock member (152) is slidably coupled to the socket body (151), and
if the lock member (152) is slid in a locking position relative to the socket body (151) so that the test socket (150) is in a locked condition, then the locking pin (192a, 192b, 192c, 192d) and the lock member (152) lock with each other.

3. The system (100) according to claim 1 or 2, wherein
the lock member (152) is slidably coupled to the socket body (151), and
if the lock member (152) is slid in a release position so that the test socket (150) is in a released condition, then the locking pin (192a, 192b, 192c, 192d) unlocks with the lock member (152), so that the test socket (150) can be removed from and lowered to the test board (190).

4. The system (100) according to any one of the claims 1 to 3, wherein the system (100) further comprises:
a stop mechanism (160) arranged between the lock member (152) and the socket body (151), the stop mechanism (160) being configured for locking the lock member (152) in a locking position and in a release position.

5. The system (100) according to any one of the claims 1 to 4, wherein the system (100) further comprises:
a mounting tool (120) comprising a force transmission element (124a, 124b), and wherein the lock member (152) comprises an opposite force transmission element (154a, 154b), wherein the force transmission element (124a, 124b) and the opposite force transmission element (154a, 154b) engage with each other so that the mounting tool (120) enables to move the lock member (152) by hand from the locking position to the release position, and from the release position to the locking position.

6. The system 100 according to claim 5, wherein
the mounting tool (120) further comprises a hook (125a, 125b, 125c, 125d) and the socket body (151) further comprises a latch (165a, 165b, 165c, 165d),
wherein the hook (125a, 125b, 125c, 125d) and the latch (165a, 165b, 165c, 165d) do not engage with each other when the test socket 150 is in the locked condition so that the mounting tool (120) and the test socket (150) are removable from each other.

7. The system 100 according to claim 6, wherein
the hook (125a, 125b, 125c, 125d) and the latch (165a, 165b, 165c, 165d) do engage when test socket (150) is in the released condition so that the mounting tool (120) and the test socket (150) are fixed to each other.

8. A test board (190) for testing electronic components (930) in an automated test equipment (900), wherein the test board (190) comprises:
a printed circuit board (191) and a locking pin (192a, 192b, 192c, 192d) extending from the printed circuit board (191), wherein the locking pin (192a, 192b, 192c, 192d) is adapted to lock with a lock member (152) of a test socket (150) so that the test socket (150) and the test board (190) are fixed to each other.

9. A test socket (150) for testing electronic components (930) in an automated test equipment (900), wherein the test socket (150) comprises:
a lock member (152) and a socket body (151), the lock member (152) being coupled to the socket body (151), wherein the lock member (152) is adapted to lock with a locking pin (192a, 192b, 192c, 192d) extending from a printed circuit board (191) so that the test socket (150) and the test board (190) are fixed to each other.

## Amended claims

### Amended claims in accordance with Rule 137(2) EPC.

1. A system (100) for mounting a test socket (150) and a test board (190) to each other, wherein the test socket (150) and the test board (190) are usable in an automated test equipment (900) to test electronic components (930), wherein the system (100) comprises:
a test board (190) comprising a printed circuit board (191) and a locking pin (192a, 192b, 192c, 192d) extending from the printed circuit board (191),
a test socket (150) comprising a socket body (151) and a lock member (152) coupled to the socket body (151), wherein
the locking pin (192a, 192b, 192c, 192d) and the lock member (152) can lock with each other so that the test socket (150) and the test board (190) are fixed to each other, wherein
the lock member (152) is slidably coupled to the socket body (151), and
if the lock member (152) is slid in a locking position relative to the socket body (151) so that the test socket (150) is in a locked condition, then the locking pin (192a, 192b, 192c, 192d) and the lock member (152) lock with each other, wherein
the lock member (152) is slidably coupled to the socket body (151), and
if the lock member (152) is slid in a release position so that the test socket (150) is in a released condition, then the locking pin (192a, 192b, 192c, 192d) unlocks with the lock member (152), so that the test socket (150) can be removed from and lowered to the test board (190),
a stop mechanism (160) arranged between the lock member (152) and the socket body (151), the stop mechanism (160) being configured for locking the lock member (152) in a locking position and in a release position, and
a mounting tool (120) comprising a force transmission element (124a, 124b), and wherein the lock member (152) comprises an opposite force transmission element (154a, 154b), wherein
the force transmission element (124a, 124b) and the opposite force transmission element (154a, 154b) engage with each other so that the mounting tool (120) enables to move the lock member (152) by hand from the locking position to the release position, and from the release position to the locking position.

2. The system 100 according to claim 1, wherein
the mounting tool (120) further comprises a hook (125a, 125b, 125c, 125d) and the socket body (151) further comprises a latch (165a, 165b, 165c, 165d),
wherein the hook (125a, 125b, 125c, 125d) and the latch (165a, 165b, 165c, 165d) do not engage with each other when the test socket 150 is in the locked condition so that the mounting tool (120) and the test socket (150) are removable from each other.

3. The system 100 according to claim 2, wherein
the hook (125a, 125b, 125c, 125d) and the latch (165a, 165b, 165c, 165d) do engage when test socket (150) is in the released condition so that the mounting tool (120) and the test socket (150) are fixed to each other.

4. A test board (190) for testing electronic components (930) in an automated test equipment (900), wherein the test board (190) comprises:
a printed circuit board (191) and a locking pin (192a, 192b, 192c, 192d) extending from the printed circuit board (191), wherein the locking pin (192a, 192b, 192c, 192d) is adapted to lock with a lock member (152) of a test socket (150) according to claim 5, so that the test socket (150) and the test board (190) are fixed to each other.

5. A test socket (150) for testing electronic components (930) in an automated test equipment (900), wherein the test socket (150) comprises:
a lock member (152),
a socket body (151), the lock member (152) being coupled to the socket body (151), wherein the lock member (152) is adapted to lock with a locking pin (192a, 192b, 192c, 192d) extending from a printed circuit board (191) so that the test socket (150) and a test board (190) are fixed to each other, wherein
the lock member (152) is slidably coupled to the socket body (151), and
if the lock member (152) is slid in a locking position relative to the socket body (151) so that the test socket (150) is in a locked condition, then the locking pin (192a, 192b, 192c, 192d) and the lock member (152) lock with each other, wherein
the lock member (152) is slidably coupled to the socket body (151), and
if the lock member (152) is slid in a release position so that the test socket (150) is in a released condition, then the locking pin (192a, 192b, 192c, 192d) unlocks with the lock member (152), so that the test socket (150) can be removed from and lowered to the test board (190),
a stop mechanism (160) arranged between the lock member (152) and the socket body (151), the stop mechanism (160) being configured for locking the lock member (152) in a locking position and in a release position, and
a mounting tool (120) comprising a force transmission element (124a, 124b), and wherein the lock member (152) comprises an opposite force transmission element (154a, 154b), wherein
the force transmission element (124a, 124b) and the opposite force transmission element (154a, 154b) engage with each other so that the mounting tool (120) enables to move the lock member (152) by hand from the locking position to the release position, and from the release position to the locking position.
